# EUROPÄISCHE PATENTSCHRIFT

(11) **EP 0 615 267 B1**
(45) Veröffentlichungstag und Bekanntmachung des Hinweises auf die Patenterteilung: **15.01.1997**
(21) Anmeldenummer: 93114752.4
(22) Anmeldetag: 14.09.1993
(51) Int. Cl.: H01H 47/00

(54) **Schaltungsanordnung zum Prüfen von Schalter-bzw. Relaiskontakten**
Circuit for testing switch- or relay contacts
Circuit de test des contacts d'interrupteur ou de relais

(30) Priorität: 08.03.1993 CH 695/93
(43) Veröffentlichungstag der Anmeldung: 14.09.1994
(73) Patentinhaber: Landis & Gyr Technology Innovation AG, 6301 Zug (CH)
(72) Erfinder: Hickl, Erich, El.-Techniker, D-7502 Malsch (DE)
(74) Vertreter: Müller, Hans-Jürgen, Dipl.-Ing.

(56) Entgegenhaltungen:
- DE-A- 2 432 043
- US-A- 3 699 300

## Beschreibung

Die Erfindung bezieht sich auf die im Oberbegriff des Patentanspruchs 1 genannte Schaltungsanordnung sowie auf eine bevorzugte Verwendung derselben.

In der Steuer- bzw. Regelungstechnik werden zum Steuern bzw. Regeln von Prozessen Steuer- bzw. Regelaggregate verwendet. Um diese ein- bzw. auszuschalten, ist es bekannt, Schalter bzw. Relais zu verwenden, deren Schaltkontakte bzw. bewegbare Schaltelemente in der Ruhestellung eine bestimmte Position einnehmen, in der der sogenannte "Ruhekontakt" kontaktiert ist, während sie in einer anderen Schalterstellung vom Ruhekontakt abhebbar und an einen anderen Kontakt anlegbar sind. Aus sicherheitstechnischen Gründen ist es für den sicheren Betrieb der Steuereinrichtung bzw. des dadurch gesteuerten, insbesondere geregelten Betriebs wichtig, daß eine Überprüfung der Kontakte der Schalter bzw. Relais stattfindet, um sicherzustellen, daß im Falle einer Fehlfunktion, beispielsweise dann, wenn in der Ruhestellung gar nicht der Ruhekontakt, sondern ein anderer Kontakt vom Schalter kontaktiert wird, der Prozeß aufgehalten wird oder gar nicht erst anlaufen kann.

Bei dem aus der US-A-3 699 300 bekannten Stand der Technik werden zwei in Reihe geschaltete und von einer Steuereinrichtung gesteuerte Schalter von je einem hochohmigen Widerstand überbrückt, so daß der den beiden Schaltern vorgeschaltete Sicherheitschalter anspricht, wenn einer der beiden Schalter ausfällt, ohne daß der vorgeschaltete Sicherheitsschalter selbst auf Funktionsfähigkeit seiner Kontakte prüfbar ist.

Der Erfindung liegt die Aufgabe zugrunde, eine solche insbesondere sicherheitstechnisch bedingte Prüfung auf die ordnungsgemäße Funktionsfähigkeit zweier Kontakte solcher Schalter bzw. Relais mit einfachen Mitteln ausführbar zu machen.

Die Erfindung ist im Patentanspruch 1 gekennzeichnet. In den Unteransprüchen sind weitere Ausbildungen der Erfindung beansprucht.

Gemäß der Erfindung wird zwischen den Ruhekontakten der beiden Schalter einerseits eine Parallelschaltung zur Spannungsquelle bzw. einem Pol derselben über jeweils einen Widerstand hergestellt. Andererseitswerden die beiden Widerstände an einen Ladekondensator angelegt, der die Steuereinrichtung bei Erreichen einer bestimmten elektrischen Ladung aktiviert. Im ausgeschalteten, d.h. Ruhezustand der beiden Schalter, wenn das bewegbare Schaltelement jeweils an dem zugehörigen Ruhekontakt anliegt, ist der Pol der Spannungsquelle je über einen Widerstand an den Ladekondensator angelegt. Der Ladekondensator wird über die beiden in diesem Fall Parallel an den Pol der Spannungsquelle liegenden Widerstände und insbesondere einen in Reihe geschalteten Kopplungswiderstand und Gleichrichter aufgeladen, so daß er bei ausreichender Netzspannung nach einer bestimmten Zeit die Schwellenspannung erreicht und ggf. über einen zusätzlichen Schwellenschalter die Steuereinrichtung betätigt, beispielsweise einen bestimmten Programmablauf startet. Ist dagegen die Ruhekontakt-Stellung einer der beiden Kontakte unterbrochen und/oder befindet sich die Spannung unterhalb eines Mindestspannungswerts, dann wird der Ladekondensator nicht genügend aufgeladen, wird die Schwellenspannung nicht erreicht und kann die Steuereinrichtung nicht entsprechend initiiert werden, wodurch auch der Programmablauf nicht gestartet wird. Hierdurch findet eine sichere Kontaktüberwachung der Schaltkontakte im Strompfad beispielsweise von Brennstoffventilen von Brennern statt. Die Sicherheit wird dadurch erreicht, daß im Falle einer Fehlfunktion von einem der Schalter SKa, SKc diese Fehlfunktion erkannt wird mit der Reaktion, daß der andere Schalter nicht aktiviert wird. Damit wird im Fehlerfall das Brennstoffventil nicht fälschlich angesteuert.

Gleichzeitig mit der Kontaktüberwachung der Schalter SKa und SKc kann aber auch die Netzspannung detektiert werden, so daß bei Unterspannung, wenn der Ladekondensator nicht bis auf eine bestimmte Schaltschwelle aufgeladen wird, keine Inbetriebsetzung erfolgt.

Es empfiehlt sich, die beiden Widerstände nicht gleich groß zu wählen, sondern ihnen unterschiedliche Ohm-Werte zuzuordnen und zwar derart, daß die Reihenschaltung des Kopplungswiderstands mit dem an einen Pol, z.B. N-Pol, angeschlossenen Widerstand hochohmig ist gegenüber der Reihenschaltung desselben Kopplungswiderstands mit der Parallelschaltung des genannten Widerstands und des anderen über die Ruhekontakte der beiden Schalter an den Pol, z.B. N-Pol, angeschlossenen Widerstands. Hierdurch wird folgendes erreicht: Der Ladekondensator wird mit dem Strom aufgeladen, der sich aus der Reihenschaltung des Kopplungswiderstands mit der genannten Parallelschaltung der beiden Widerstände (sowie einem Gleichrichter und einer Kapazität) ergibt, dabei entspricht die Ladespannung der Netzspannung zwischen den Netzpolen z.B. N und L.

Darüber hinaus ist es auch möglich, eine zusätzliche Schutzschaltung zu verwenden, die den gleichzeitigen Ausfall beider Kontakte feststellt und die Steuereinrichtung dann blockiert und/oder eine Anzeigeeinrichtung, beispielsweise eine Alarmanlage, auslöst.

Nach einer besonderen Ausbildung der Erfindung findet diese Anwendung bei einem Feuerungsautomaten für z.B. Gasbrenner statt. Dabei wird einer der beiden Schalter bzw. Relais dem Brennstoffventil und der andere den Schalter bzw. Relais der Versorgungsspannung zugeordnet, damit sichergestellt ist, daß erst bei Bestehen eines bestimmten Gasdruckes am Brennstoffventil die Steuereinrichtung in Funktion tritt.

Ausführungsbeispiele der Erfindung werden nun anhand der Zeichnung näher erläutert. Dabei zeigen:
- Fig. 1: ein schematisches Prinzipschaltbild der Erfindung;
- Fig. 2: eine bevorzugte Schaltungsanordnung in ihrer speziellen Bestückung mit Transistoren;
- Fig. 3: eine schematische Darstellung der bei einem Feuerungsautomaten für Gasbrenner angewendeten Erfindung und
- Fig. 4: vier Funktionsdiagramme I, II, III und IV für einzelne Aggregate des Feuerungsautomaten in Abhänigkeit von der Zeit.

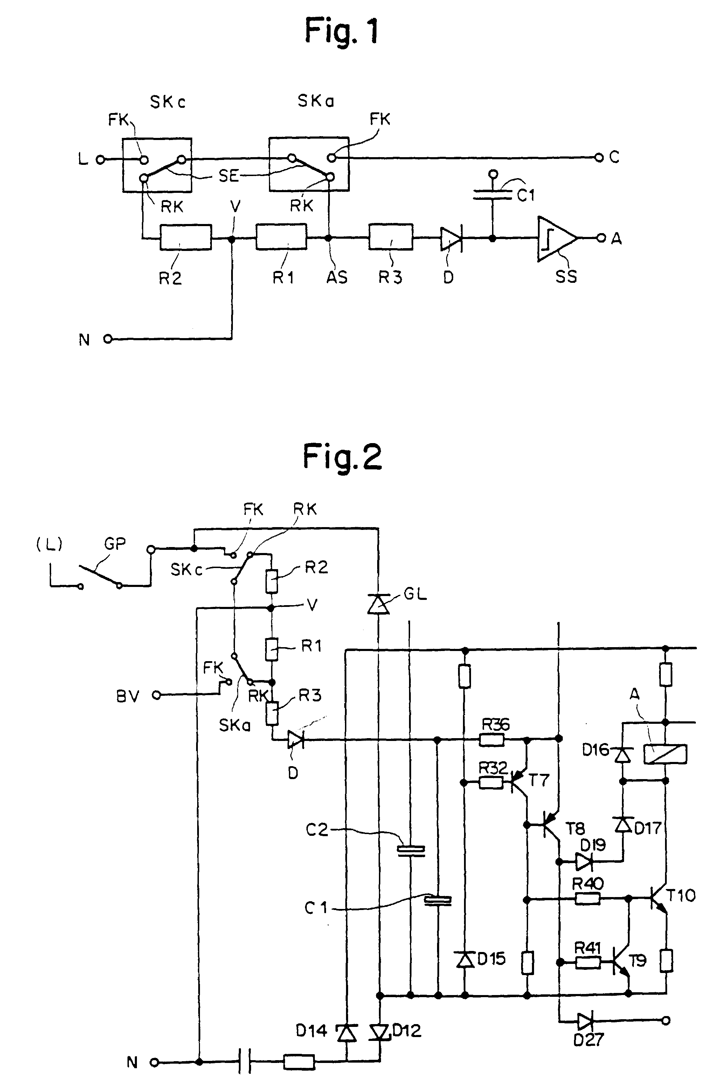

Gemäß Fig. 1 sind die Schaltkontakte SKa, SKc zweier Schalter bzw. Relais A, C derart elektrisch miteinander verbunden, daß die einen Enden des bewegbaren Schaltelements SE miteinander verbunden sind, während die Ruhekontakte RK, an denen die bewegbaren Schaltelement SE in der ausgeschalteten, d.h. in der Ruhestellung anliegen, über zwei in Reihe geschaltete Widerstände R1, R2 miteinander verbunden sind. Die Verbindungsstelle V der beiden Widerstände R1, R2 ist an einen Pol N einer Spannungsquelle angelegt, während der in dieser Stellung freie Kontakt FK des Schalter SKa am anderen Pol L der Spannungsquelle liegt. Der freie Kontakt FK des anderen Schalters SKc ist an das Relais C beispielsweise eines Brennerventils angelegt, um diese an Spannung zu legen, wenn beide Schaltelemente SE der beiden Schalter SKa und SKc nicht an den Ruhekontakten RK, sondern an den freien Kontakten FK in der eingeschalteten Funktionsstellung anliegen. Die Anschlußstelle AS zwischen dem Ruhekontakt RK des Schalters SKc und dem Widerstand R2 ist an einen Kopplungswiderstand R3 und dieser an einen als Diode ausgebildeten Gleichrichter D angelegt, so daß dem Ladekondensator C1 bei Auftreten einer Spannung aufladbar ist. In Abhängigkeit von der dann vorliegenden Spannung spricht ein Schwellenschalter SS an, um bei Erreichen einer vorbestimmten Schwellenspannung das Relais A zu initiieren. Befinden sich die beiden Schaltelemente SE beider Schalter SKa, SKc in der Ruhestellung wie vorgeschrieben an den Ruhekontakten RK, dann fließt einerseits über den Widerstand R2 unmittelbar und andererseits über den Widerstand R1 sowie die beiden Schaltelemente SE andererseits ein netzspannungsabhängiger Strom, welcher zum Laden des Ladekondensators C1 führt. Hat eines der beiden Schaltelemente SE fehlerhafterweise nicht die Ruhestellung am Ruhekontakt RK eingenommen, dann fällt der Widerstand R1 zum Aufladen des Ladekondensators C1 aus, so daß bei entsprechender Bemessung der Bauelemente keine genügende Schwellenspannung zum Initiieren der Steuereinrichtung bzw. des Relais A auftritt. Das gleiche Ergebnis, nämlich das Nicht-Erreichen der Schwellenspannung tritt dann ein, wenn am Pol N der Spannungsquelle keine genügend große Spannung erreicht wird. Insofern eignet sich die erfindungsgemäße Schaltungsanordnung auch als Schutzschaltung gegen zu niedrige Spannungen der Spannungsquelle.

Bei dem Ausführungsbeispiel der Fig. 2 ist der Schaltkontakt SKc mit seinem freien Kontakt FK an einen Gasdruckwächter GP angeschlossen, während der freie Kontakt FK des anderen Schalters SKa am Brennstoffventil BV liegt. Die Reihenschaltung der parallelgeschalteten Widerstände R2, R1 mit dem Kopplungswiderstand R3 und dem Gleichrichter D liegen an dem Ladekodensator C1, dessen anderer Anschluß über eine Gleichrichter-Diode GL an den Gasdruckwächter GP liegt, wodurch sich der Ladestromzweig zum anderen Pol L ergibt. Erreicht der Ladekondensator C1 eine bestimmte Schwellenspannung, was dann der Fall ist, wenn sich die Schalter SKa, SKc in der richtigen Ruhestellung befinden, dann erreicht auch der Transitor T7 die Schaltschwelle von beispielsweise 8 V, wodurch der Transistor T10 das Relais A ansteuert und hierdurch die Steuereinrichtung initiiert, d.h. der Programmablauf gestartet wird. Der Kondensator C2 dient zum Glätten der Versorgungsspannung.

Ist die Ruhekontaktstellung eines der Schalter SKa, SKc unterbrochen und/oder befindet sich die Spannung unterhalb eines vorbestimmten Nennspannungsbereichs, dann wird die Schaltschwelle des Transistors T7 nicht erreicht und kann der Programmablauf nicht gestartet werden.

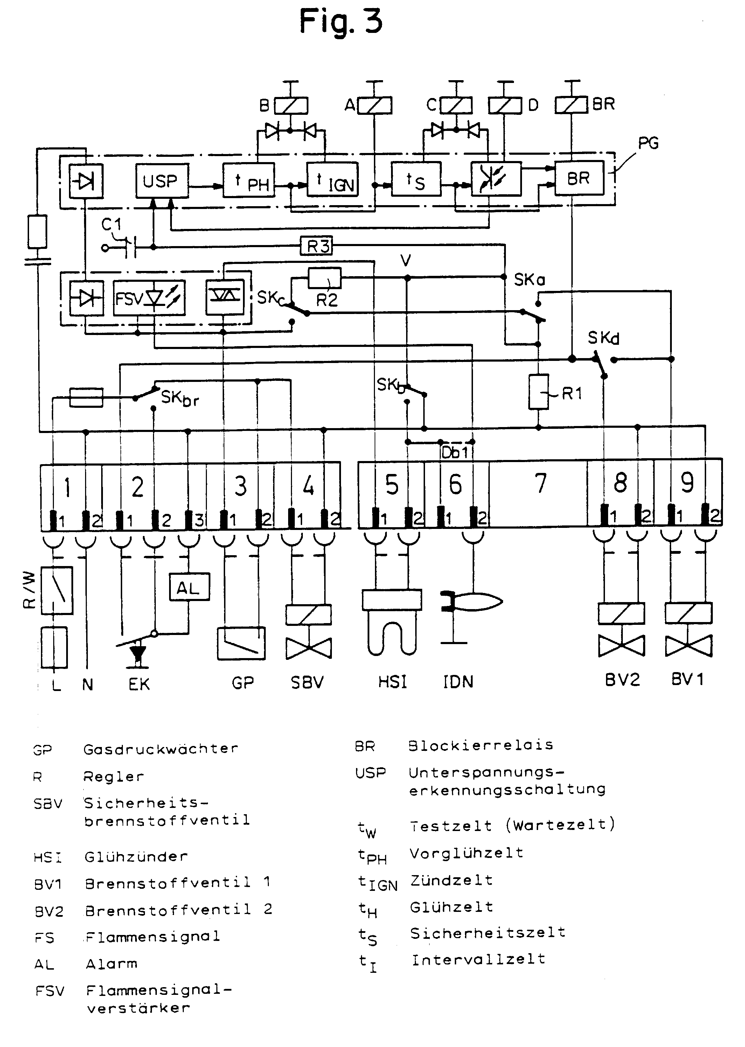

Das besonders bevorzugte Anwendungsbeispiel wird nun anhand der Fig. 3 erläutert, in der auch die Kurzbezeichnungen der einzelnen Aggregate angegeben sind.

Der schematisch hinsichtlich seiner Anschlüsse und Baugruppen in Fig. 3 dargestellte Feuerungsautomat für atmosphärische Gasbrenner niedriger Leistung bis zu etwa 70 kVA ist über die Anschlüsse 1 - 6 und 8 - 9 an folgende Aggregate angeschlossen:
1. über den Schalter R/W an das Wechselspannungsnetz mit den Polen L, N einer Wechselspannung von 230 v
2. an den Entstörtaster EK unter Zwischenschaltung eines Alarmgebers AL
3. an den Gasdruckwächter GP
4. an das Sicherheits-Brennstoffventil SBV
5. an den Glühzünder HSI, der in seiner bevorzugten Ausbildung zwar für 120 V Wechselspannung ausgelegt ist aber mit den Netzspannung von 230 V betreibbar ist, da er durch Pulsweitenmodulation nicht sämtliche Teile der Wechselspannungswellen zugeführt erhält
6. die Fühlerelektrode des Flammenfühlers ION
7. für weitere Elemente als Option vorgesehen
8. das Brennstoffventil 2 BV2 und
9. das Brennstoffventil 1 BV1, da es sich hier um einen zweistufigen Brenner handelt.

Der Programmgeber PG steuert das Relais B für den Glühzünder HSI, die Relais A und C für das Brennstoffventil BV1 und das Relais D für das weitere Brennstoffventil BV2 und das Relais BR für die Gesamtschaltung im Fehlerfall.

Entsprechend sind im Programmgeber PG verschiedene Steuerstufen symbolisiert mit folgender Bedeutung:
- USP:: Unterspannungserkennungsschaltung
- t_{PH}:: Vorglühzeit
- t_{IGN}:: Zündzeit
- t_{S}:: Sicherheitszeit
- BR:: Blockierrelais

Zwischen dem Gasdruckwächter GP und dem Glühzünder HSI ist eine TRIAC-Schaltstufe und ein Flammensignalverstärker FVS eingeschaltet, der das Signal des Flammenfühlers ION auswertet und seinerseits ein Ausgangssignal an den Programmgeber PG abgibt.

Die erfindungsgemäße Schaltungsanordnung verknüpft die Anschlüsse mit dem Programmgeber PG in der schaltbildmäßig gezeigten Art. Dabei sind der Schalter SKa des Relais A und der Schalter SKc des Relais C hinsichtlich ihrer bewegbaren Schaltelemente miteinander verbunden. Darüber hinaus sind die Ruhekonzakte über die beiden Widerstände R1, R2 miteinander verbunden, deren Verbindungsstelle V an den Ruhekontakt des Schalters SKb des Relais B gelegt ist, dessen anderer Kontakt mit dem Glühzünder HSI in Verbindung steht, um diesen bei Initiierung des Relais B an Spannung zu legen. Da das bewegbare Schaltelement des Schalters SKb am Pol N der Spannungsquelle liegt, wird im Ruhezustand des Schalters SKb die Verbindungsstelle V an den gleichen Pol N gelegt, so daß die Spannung über den Widerstand R3 an den Ladekondensator C1 gelangt und in Abhängigkeit vom Überschreiten einer vorbestimmten Schwellenspannung der Programmgeber PG über die Unterspannungserkennungsschaltung USP zum erfindungsgemäßen Kontakttest steuerbar ist.

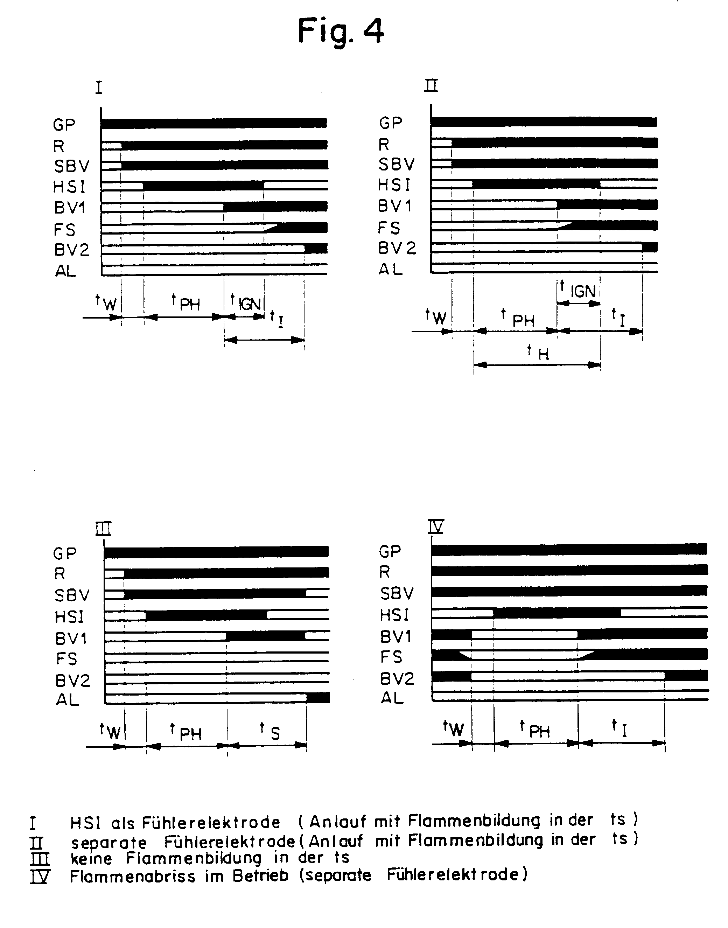

Die in durchgezogenen dicken Linien in Fig. 4 schematisierten Kurvenzüge geben die Inbetriebsetzung der betreffenden Aggregate an, wonach in allen drei Funktionsdiagrammen der Gasdruckwächter GP genügenden Gasdruck in der Gaszuführung zum Brenner attestiert und der Regler R bei den Funktionsdiagrammen I, II und III den Programmstart einleitet. Das Sicherheitsventil SBV ist jeweils während des Betriebs des Reglers R in Tätigkeit. Der Glühzünder HSI ist um eine zeitliche Verzögerung (während dieser Testzeit t_{w} findet die Kontaktprüfung, d.h. die Aufladung des Ladekondensators C1 statt) nach dem Beginn der Regelung R initiiert. Von diesem Zeitpunkt der Aktivierung des Glühzünders HSI beginnend findet die Vorglühzeit t_{PH} bis zum Beginn der Öffnung des ersten Gas- bzw. allgemeinen Brennstoffventils BV1 statt, worauf in den Funktionsdiagrammen I und II die Zündzeit t_{IGN} beginnt, so daß der Glühzünder HSI während der Gesamtglühzeit T_{H} aktiviert ist. Die Intervallzeit t_{I} ist derjenige Zeitraum zwischen dem Einschalten des ersten Brennstoffventils BV1 und dem Einschalten des zweiten Brennstoffventils BV2. Ein Alarm wird nach dem Funktionsdiagramm III ausgelöst, wenn der Flammenfühler während der Sicherheitszeit t_{S} keine Flammenbildung feststellt, was zum Ausschalten führt, während die Funktionsdiagramme I und II das Anlaufen des Feuerungsautomaten mit Flammenbildung während der Sicherheitszeit t_{S} repräsentieren. Das Funktionsdiagramm IV stellt schematisch die Verhältnisse beim Flammenabriß während des Reglerbetriebes dar; bildet sich bei dem anschließenden Heustart innerhalb der Sicherheitszeit tₛ wieder eine Flamme, dann wird auch wieder die Betriebsstellung erreicht. Die erfindungsgemäße Schaltungsanordnung gewährleistet, daß die Funktionssicherheit der Relais A, C mit ihren Schaltern SKa, SKc voll funktioniert.

Die Erfindung ermöglicht daher nicht nur die Lösung der genannten Aufgabe, sondern in Form einer besonderen Ausbildung auch die Feststellung nicht ausreichender Spannung mit der Folge, daß bei zu geringer Spannung, d.h. bei "Unterspannung", sicherheitstechnische Maßnahmen ergriffen und z.B. der Betrieb ausgeschaltet oder gar nicht erst eingeschaltet wird.

## Patentansprüche

1. Schaltungsanordnung zum Prüfen von zwei in Reihe geschalteten und an eine Spannungsquelle anlegbaren Kontakten von Schaltern bzw. Relais, die von einer Steuereinrichtung steuerbar sind,
**dadurch gekennzeichnet,**
daß die Ruhekontakte (RK) der beiden Schalter (SKa, SKc) parallel über je einen elektrischen Widerstand (R1, R2) an einen Pol (N) der Spannungsquelle anschließbar sind, welche einen Ladekondensator (C1) über die Parallelschaltung der beiden Widerstände (R1, R2) auflädt, der bei Erreichen einer bestimmten elektrischen Ladung bzw. elektrischen Spannung die Steuereinrichtung aktiviert.

2. Schaltungsanordnung nach Anspruch 1,
**dadurch gekennzeichnet,**
daß der Ladekondensator (C1) über einen Schwellenschalter (SS) an die Steuereinrichtung gelegt ist.

3. Schaltungsanordnung nach Anspruch 1 oder 2,
**dadurch gekennzeichnet,**
daß die Reihenschaltung der beiden Widerstände (R1, R2) über einen Kopplungswiderstand (R3) und einen Gleichrichtet (D) an den Ladekondensator (C1) angeschlossen ist.

4. Schaltungsanordnung nach einem der vorhergehenden Ansprüche,
**dadurch gekennzeichnet,**
daß die beiden Widerstände (R1, R2) unterschiedliche Ohm-Werte aufweisen und daß die Reihenschaltung des einen Widerstands (R1) mit dem Kopplungswiderstand (R3) hochohmig gegenüber der Reihenschaltung des Kopplungswiderstands (R3) mit der Parallelschaltung beider Widerstände (R1, R3) bemessen ist.

5. Schaltungsanordnung nach einem der vorhergehenden Ansprüche,
**dadurch gekennzeichnet,**
daß eine Schutzschaltung den Ausfall eines der beiden Kontakte der Schalter (SKa, SKc) feststellt und die Steuereinrichtung blockiert.

6. Schaltungsanordnung nach einem der vorhergehenden Ansprüche,
**dadurch gekennzeichnet,**
daß eine Unterspannungserkennungsschaltung (USP) nicht genügende Aufladung des Ladekondensators (C1) im Falle der Ruhekontaktschaltung beider Schalter (SKa, SKc) und ungenügender Netzspannung feststellt und die Inbetriebnahme der Steuereinrichtung verhindert.

7. Verwendung der Schaltungsanordnung nach einem oder mehreren der vorhergehengen Ansprüche für einen Feuerungsautomaten mit der Maßgabe, daß ein Schaltkontakt dem Schalter (Ska) bzw. Relais (A) eines Druckwächters und der andere Schaltkontaktdem Schalter (Skc) bzw. Relais (C) für ein Brennstoffventil (BV) zugeordnet sind.

## Claims

1. A circuit arrangement for testing two series-connected contacts. which can be applied to a voltage source, of switches or relays which are controllable by a control device, characterised in that the rest contacts (RK) of the two switches (SKa, SKc) can be connected in parallel by way of a respective electrical resistor (R1, R2) to a pole (N) of the voltage source which by way of the parallel circuit of the two resistors (R1, R2) charges up a charging capacitor (C1) which activates the control device upon the attainment of a given electrical charge or electrical voltage.

2. A circuit arrangement according to claim 1 characterised in that the charging capacitor (C1) is connected to the control device by way of a threshold switch (SS).

3. A circuit arrangement according to claim 1 or claim 2 characterised in that the series circuit of the two resistors (R1, R2) is connected to the charging capacitor (C1) by way of a coupling resistor (R3) and a rectifier (D).

4. A circuit arrangement according to one of the preceding claims characterised in that the two resistors (R1, R2) have difference ohmic values and that the series circuit of the one resistor (R1) with the coupling resistor (R3) is of high resistance relative to the series circuit of the coupling resistor (R3) with the parallel circuit of the two resistors (R1, R3).

5. A circuit arrangement according to one of the preceding claims characterised in that a protective circuit detects the failure of one of the two contacts of the switches (SKa, SKc) and blocks the control device.

6. A circuit arrangement according to one of the preceding claims characterised in that an undervoltage detection circuit (USP) detects inadequate charging of the charging capacitor (C1) in the case of the rest contact circuit of the two switches (SKa, SKc) and inadequate mains voltage and prevents the control device from coming into operation.

7. Use of the circuit arrangement according to one or more of the preceding claims for an automatic firing arrangement with the proviso that a switching contact is associated with the switch (SKa) or relay (A) of a pressure monitor and the other switching contact is associated with the switch (SKc) or relay (C) for a fuel valve (BV).

## Revendications

1. Agencement de circuits pour contrôler deux contacts d'interrupteurs ou de relais montés en série et applicables à une source de tension, qui peuvent être contrôlés par un dispositif de commande,
caractérisé
en ce que les contacts de repos (RK) des deux interrupteurs (SKa, SKc) peuvent être connectés en parallèle, via, respectivement, une résistance électrique (R1, R2), à un pôle (N) de la source de tension qui charge un condensateur de charge (C1), via le montage en parallèle des deux résistances (R1, R2), lequel condensateur active le dispositif de commande lorsqu'une certaine charge électrique ou tension électrique est atteinte.

2. Agencement de circuits selon la revendication 1, caractérisé en ce que le condensateur de charge (C1) est relié au dispositif de commande via un interrupteur de seuil (SS).

3. Agencement de circuits selon la revendication 1 ou 2, caractérisé en ce que le montage en série des deux résistances (R1, R2) est connecté au condensateur de charge (C1), via une résistance de couplage (R3) et un redresseur (D).

4. Agencement de circuits selon l'une quelconque des revendications précédentes, caractérisé en ce que les deux résistances (R1, R2) présentent des valeurs ohmiques différentes, et en ce que le montage en série de l'une des résistances (R1), avec la résistance de couplage (R3), est dimensionné avec une valeur ohmique élevée par rapport au montage en série de la résistance de couplage (R3) avec le montage en parallèle des deux résistances (R1, R2).

5. Agencement de circuits selon l'une quelconque des revendications précédentes, caractérisé en ce qu'un circuit de protection constate la panne de l'un des deux contacts des interrupteurs (SKa, SKc), et en ce qu'il bloque le dispositif de commande.

6. Agencement de circuits selon l'une quelconque des revendications précédentes, caractérisé en ce qu'un circuit de détection de sous-tension (USP) constate une charge insuffisante du condensateur de charge (C1) dans le cas du circuit des contacts de repos des deux interrupteurs (SKa, SKc) et dans le cas d'une tension de secteur insuffisante, et en ce qu'il empêche la mise en route du dispositif de commande.

7. Utilisation de l'agencement des circuits selon l'une quelconque ou plusieurs des revendications précédentes pour un dispositif automatique de chauffe présentant la caractéristique selon laquelle un contact de commutation est affecté à l'interrupteur (SKa) ou au relais (A) d'un manostat, et selon laquelle l'autre contact de commutation est affecté à l'interrupteur (SKc) ou au relais (C) pour une valve de combustible (BV).
